Europäisches Patentamt

European Patent Office

Office européen des brevets

(11) Publication number: **0 429 070 A2**

# EUROPEAN PATENT APPLICATION

(21) Application number: 90122203.4

(22) Date of filing: 20.11.90

(51) Int. Cl.⁵: **C23C 18/14**, C23C 18/30, C23C 16/02

(30) Priority: 21.11.89 DE 3938669

(43) Date of publication of application:
29.05.91 Bulletin 91/22

(84) Designated Contracting States:
AT BE CH DE DK ES FR GB GR IT LI LU NL SE

(71) Applicant: Max-Planck-Gesellschaft zur Förderung der Wissenschaften e.V.
Bunsenstrasse 10
W-3400 Göttingen(DE)

(72) Inventor: Stuke, Michael
Auf der Lieth 34
W-3400 Göttingen(DE)
Inventor: Zhang, Yanping
Im Winkel
W-3400 Göttingen(DE)
Inventor: Gottsleben, Oliver
Klinkerfuesstrasse 19
W-3400 Göttingen(DE)

(74) Representative: von Bezold, Dieter, Dr. et al
Dr. Dieter von Bezold Dipl.-Ing. Peter Schütz
Dipl.-Ing. Wolfgang Heusler Brienner Strasse 52
W-8000 München 2(DE)

(54) Synchrotron radiation processing of a surface to be metallised.

(57) Method of seeding a substrate surface to be metallised, especially by electroless plating, in which the surface is coated with a layer of a substance, such as palladium acetate, which can furnish seeds or nucleation sites for a chemical deposition of metal, such as copper, and which substance is decomposed by synchrotron radiation of an intensity which effects a substantially photolytic but not thermal decomposition of the substance.

EP 0 429 070 A2

## SYNCHROTRON RADIATION PROCESSING OF A SURFACE TO BE METALLISED

The present invention relates to a method of seeding the surface of a substrate, i.e. providing it with nucleation sites, to make it possible to metallise the surface, preferably by an electroless deposition method.

A method of seeding a surface to be metallised using short wave optical radiation to decompose a compound of seeding substance is known from the publication of Esrom et al, Mat. Res. Soc. Symp. Proc. (1989) 131, 581.

In another known method of this kind, excimer laser radiation with wavelengths of 308 nm, 248 nm and 193 nm is used to create seeds for a subsequent electroless metallisation.

In the known methods palladium seeds or nucleation sites are created by photo-thermal decomposition of palladium acetate by means of KrF excimer laser pulses of high power, e.g. with current flux values of the order of magnitude of $10^4$ W $cm^{-2}$ and radiation power densities of the order of magnitude of 1 J $cm^{-2}$.

The present method solves the problem of providing a method such that a higher local resolution and/or seeding with lower flux densities can be achieved. In accordance with the invention this is achieved in that the seeding is effected by means of synchrotron radiation of a wave-length in the vacuum ultraviolet region.

It has surprisingly been discovered that seeding by irradiation of a suitable precursor layer, especially a palladium acetate layer, with synchrotron radiation in the vacuum ultraviolet spectral region (VUV) can be achieved even with flux values below $10^{16}$ photons $s^{-1}$ $cm^{-2}$, e.g. $5 \cdot 10^{15}$ photons $s^{-1}$ $cm^{-2}$, the process not acting as heretofore mainly as a photo-thermic process but mainly as a photolytic process.

In the purely photo-chemical seeding, in contrast to the excimer seeding, there thus arises no power flux threshold and it is therefore possible to seed also very heat-sensitive substrates, such as semiconductor heterostructures, plastics, etc.

The duration of the irradiation is preferably at least 5 minutes, especially more than 10 minutes, and may amount to about 60 minutes.

In implementing the invention there can be used for example synchrotron radiation in the wavelength range of about 40 to 300 nm, preferably radiation with a wavelength less than 180 nm. Especially advantageous is radiation with a substantially continuous wavelength distribution (in contrast to line radiation).

EXAMPLE 1: A layer of palladium acetate (Pd-$(\mu$-$O_2CCH_3)_2)_3$ is produced on a surface to be metallised on a substrate by application of a solution of the palladium acetate in chloroform by means of centrifugal coating and drying the solution. A coating thickness in the range 0.05 $\mu$m to 0.15 $\mu$m is preferred.

The substrate can consist for example of aluminium oxide ceramic or silicon, or of a transparent material such as quartz, or a polymer such as a polyamide.

The substrate coated with the palladium acetate film is then placed in a high vacuum chamber, which is evacuated to a pressure of $7 \cdot 10^{-7}$ Pa $(5 \cdot 10^{-9}$ Torr), and is then irradiated with broadband synchrotron radiation in the wavelength region of about 40 to 300 nm. The duration of the irradiation can amount to e.g. 20 to 60 minutes. Then the substrate is removed from the vacuum chamber and washed with chloroform, in order to remove the non-decomposed palladium acetate.

The substrate thus prepared is then subjected to an electroless, chemical metallisation in a chopper metallising solution customary in the art, e.g. a Shipley coppering bath.

The thickness of the palladium deposit on the washed substrate amounted to about $2 \cdot 10^{-3}$ $\mu$m. Copper deposits with good adhesion and good conductivity can be produced without current to a thickness between 0.15 and 0.3 $\mu$m.

On account of the short wavelength of the synchrotron radiation, it is possible to produce structures, such as electrical conductors, with widths below 0.2 $\mu$m, with suitable masks, e.g. of tungsten or molybdenum layers.

With the method described above the surface of a transparent quartz substrate can be successfully seeded with a mean flux of $5 \cdot 10^{14}$ photons $s^{-1}$ $cm^{-2}$ (less than 3 mW $cm^{-2}$). The thermal load on the substrate is negligible with this strength of radiation, so that even sensitive substrates can be seeded and metallised without ill effects, e.g. without danger of a undesirable post-diffusion of doping materials.

Instead of the palladium acetate referred to other seed-forming substances can be used, especially organo-metallic compounds such as gold screen printing dye (Engelhard Bright; Gold NW), copper(II)acetyl-acetonate, etc.

The coating can take place by other methods, such a dipping. The chemically deposited metallisation can thereafter be strengthened electrolytically, or by thermal deposition from the gaseous phase (CVD), since the activation energy for the chemical deposition from the gaseous phase at the seeded locations is reduced. In this way the selective deposition of e.g. aluminium and tungsten is possible.

**EXAMPLE 2:** A silicon substrate having a surface seeded as described in example 1 is heated to about 200°C in vacuo and then exposed to trimethylaminealuminiumhydride (TMAAH) vapor of about 270 Pa (2 Torr) pressure for about one minute. Al deposited only on the surface portions which were Pd seeded (provided with Pd nucleation sites).

## Claims

1. Method of seeding a surface of a substrate to be metallised, in which the surface is coated with a layer of a substance which can provide seeds for the deposition of metal and the substance is decomposed by short-wave optical radiation, with the formation of seeds, **characterized in that** the decomposition is effected by synchrotron radiation with wavelengths in the vacuum ultraviolet region and an intensity which effects a substantially photolytic but not thermal decomposition of the substance.

2. Method according to claim 1, **characterized in that** synchrotron radiation with wavelengths down to at least 40 nanometer is used.

3. Method according to claim 1 or 2, **characterized in that** synchrotron radiation with wavelengths below 180 nanometer is used.

4. Method according to claim 1, 2 or 3, **characterized in that** synchrotron radiation of continuous wavelength is used.

5. Method according to one of the preceding claims, **characterized in that** the irradiation of the substrate is effected selectively.

6. Method according to one of the preceding claims, **characterized in that** the substrate surface is coated with palladium acetate.

7. Method according to one of the preceding claims, **characterized in that** the metal is deposited chemically, without current.

8. Method according to one of the preceding claims, **characterized in that** the metal is deposited by CVD.

9. Method according to one of the preceding claims, **characterized in that** the intensity of the synchrotron radiation per unit surface of the substrate is not more than $10^6$ photons $s^{-1}$ $cm^{-2}$.

10. Method according to one of the preceding claims, **characterized in that** the duration of exposure amounts to at least 5 minutes.

11. Method according to one of the preceding claims, **characterized in that** the duration of exposure amounts to at least 10 minutes.

12. Method according to one of the preceding claims, **characterized in that** the duration of exposure amounts to approximately 30 minutes.